(19) Europäisches Patentamt
European Patent Office
Office européen des brevets

(11) Publication number: **0 079 111**
**B1**

(12) **EUROPEAN PATENT SPECIFICATION**

(45) Date of publication of patent specification: **22.10.86**

(21) Application number: **82201409.8**

(22) Date of filing: **09.11.82**

(51) Int. Cl.$^4$: **H 01 L 31/02,** H 01 J 29/89, G 03 C 7/10, G 03 C 7/12

(54) **Colour imaging device.**

(30) Priority: **10.11.81 NL 8105071**

(43) Date of publication of application:
**18.05.83 Bulletin 83/20**

(45) Publication of the grant of the patent:
**22.10.86 Bulletin 86/43**

(84) Designated Contracting States:
**AT DE FR GB IT NL**

(56) References cited:
**EP-A-0 022 530**
**EP-A-0 035 886**
**DE-A-2 442 694**
**DE-B-1 128 890**
**US-A-4 081 277**

**PATENTS ABSTRACTS OF JAPAN, vol. 5, no. 181, 20th November 1981, page 853 (E83), Tokyo (JP);**

(73) Proprietor: **N.V. Philips' Gloeilampenfabrieken**
**Groenewoudseweg 1**
**NL-5621 BA Eindhoven (NL)**

(72) Inventor: **Needs, Howard Curtis**
**c/o INT. OCTROOIBUREAU B.V. Prof. Holstlaan 1**
**NL-5656 AA Eindhoven (NL)**
Inventor: **Blok, Lodewijk**
**c/o INT. OCTROOIBUREAU B.V. Prof. Holstlaan 1**
**NL-5656 AA Eindhoven (NL)**

(74) Representative: **Peters, Rudolf Johannes et al**
**INTERNATIONAAL OCTROOIBUREAU B.V. Prof. Holstlaan 6**
**NL-5656 AA Eindhoven (NL)**

**EP 0 079 111 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The invention relates to a colour imaging device comprising an imaging device having a colour filter comprising a dyed single layer provided on a substrate of the imaging device and having at least two systems of filter elements, each system of filter elements passing a different colour of light. The invention also relates to a method of manufacturing such a device.

Such a colour imaging device is known from United States Patent Specification 4,081,277 and is used for recording video images. In this known device the imaging device is formed by a semiconductor layer which has a system of photosensitive elements. A colour filter is provided directly on the system of photosensitive elements. The colour filter is formed by one layer having systems of filter elements passing light of various colours, for example, red, green and blue. In order to obtain the correct video signal, each filter element of the colour filter should be in registration with a photosensitive element of the semiconductor layer.

In manufacturing these colour filters, a transparent layer is provided on the semiconductor layer and a barrier layer is then provided thereon. A pattern of apertures is formed in the barrier layer by means of a photolithographic process. The pattern of apertures corresponds to a system of filter elements of one colour to be formed. A dye is then provided in the apertures in the barrier layer and dyes the regions of the transparent layer underlying the apertures. After dyeing, the barrier layer is removed. In this manner a first system of filter elements passing, for example, red light, is formed. The process is repeated for the formation of the systems of green and blue light-passing filter elements. The colour filter may be formed as a stripe filter or as a mosaic filter.

However, the manufacture of colour filters in the above-described manner gives rise to the occurrence of colour defects and errors in the registration of the filter elements with respect to the photosensitive elements.

When the transparent layer is dyed *via* the apertures in the barrier layer, only the regions directly underlying the apertures may be coloured. By diffusion in the direction parallel to the layer, however, dye easily travels outside the regions destined for this purpose. As a result of this, regions are formed along the edges of the filter elements in which the colours of the filter elements belonging to different systems run. In addition to, on the one hand, the requirement that the transparent layer should have a very small diffusion in the direction parallel to the layer, on the other hand the layer should of course easily absorb dye. As a result of these two requirements the number of suitable materials for the transparent layer is very much restricted.

Furthermore, in order to obtain sharp edges of the apertures in the barrier layer, a barrier layer is required having a large resolving power with respect to the photolithographic process. In addition, three very accurate photolithographic steps are required since the systems of filter elements passing light in different colours must very accurately adjoin each other and the position of the filter elements of each system should accurately correspond to the associated photosensitive elements.

It is therefore the object of the invention to provide a colour imaging device having a colour filter with which the occurrence of colour defects is largely prevented. It is a further object of the invention to provide a colour imaging device which can be manufactured in a simple manner and in which the filter elements of the colour filter are accurately in registration with the photosensitive elements of the imaging device.

A colour imaging device of a kind mentioned in the opening paragraph is for that purpose characterized in that the layer of filter elements has separation regions which completely separate the filter elements from neighbouring filter elements.

By providing separation regions between the filter elements dye for one system of filter elements is prevented from entering the region of another system of filter elements by diffusion in a direction parallel to the layer. As a result of this the occurrence of colour defects in the colour filter is reduced. Since there are substantially no restrictions any more with respect to the diffusion in a direction parallel to the layer a greater choice of materials for the layer to be dyed is available. With a colour filter according to the invention a greater accuracy is achieved in the registration of the filter elements and the photosensitive elements because, instead of three accurate photolithographic process steps, only one accurate photolithographic process step is required, namely only that for providing the separation regions. Since a smaller number of accurate photolithographic process steps is required, the colour filters can also be manufactured in a simpler manner.

A suitable embodiment is characterized in that the spearation regions are grooves provided in the layer. As a result of this, separate filter elements are present which make diffusion of dyes from one filter element to the other filter element impossible.

Another embodiment is characterized in that the separation regions comprise a material which is substantially impervious to liquid. The structure of the layer which easily absorbs dye can be converted physically or chemically into a structure which is substantially impervious to liquid. This impervious structure again prevents dye from diffusing from one filter element to other filter elements.

The filter elements can be separated in the above-described manners by separation regions which are very narrow as compared with the dimensions of the filter elements. In special cases in which a very high quality is required, the light falling through the separation region may have a disturbing effect. In that case it is necessary to make the zones at the area of the separation regions impervious to light. For that purpose, a further embodiment is characterized in that the separation regions comprise a light-impervious material, for example a vapour-deposited metal layer.

A suitable embodiment of a colour imaging device in accordance with the invention is characterized in that the imaging device comprises a semiconductor layer having a system of photosensitive elements. The imaging device is formed by a semiconductor sensor which, dependent on the construction of the sensor, comprises a stripe filter or a mosaic filter. A stripe filter is used, for example, in a sensor provided with CCD's (Charge-Coupled Devices) which is constructed as a so-called frame-transfer sensor, while a mosaic filter is used in, for example, an x-y sensor having integrated photo diodes.

A preferred embodiment is characterized in that the colour filter is provided directly on the semiconductor layer. As a result of this it is possible in a simple manner to provide colour filters the filter elements of which are accurately in registration with the photosensitive elements of the semiconductor layer. According to another embodiment, however, it is also possible to provide the colour filter on a transparent substrate and to provide said substrate on the semiconductor layer. An extra step is necessary for positioning the filter elements of the colour filter with respect to the photosensitive elements in the semiconductor layer.

The invention is particularly suitable for, but not restricted to, imaging devices in the form of a semiconductor layer having photosensitive elements. For example, according to another embodiment the imaging device may comprise a cathode-ray tube having a window portion which on its inside has a photosensitive layer, wherein the colour filter is present between the photosensitive layer and the window portion. In this embodiment the colour filter may be provided directly on the window portion of the cathode-ray tube or be provided first on a substrate which is then provided on the window portion of the tube.

A method of manufacturing an imaging device in accordance with the invention comprises the following steps:

a) providing an imaging device substrate;

b) providing a transparent layer on the substrate a transparent layer which can be coloured by dyes;

c) providing, by means of a photolithographic process, a pattern of separation regions in the transparent layer to form filter elements in the layer, which are completely separated from neighbouring filter elements;

d) providing a barrier layer over the transparent layer,

e) providing, by means of a photolithographic process, a pattern of apertures in the barrier layer, which pattern corresponds to a first system of filter elements,

f) providing, *via* the apertures in the barrier layer, a dye in the filter elements of the first system and

g) removing the barrier layer.

The steps d) to f) of the method should be repeated to form at least further systems of filter elements passing light of a different colour than the first system of filter elements. The method according to the invention has the advantage that an accurate photolithographic process step is necessary only to provide the pattern of separation regions in the transparent layer. As a result of the formation of separate filter elements the diffusion in a direction parallel to the layer need no longer be small. This provides greater choice of materials for the transparent layer to be dyed. The size of the filter elements is entirely fixed due to the provision of the separation regions and is no longer determined by the size of the apertures in the barrier layer. The size of the apertures in the barrier layer may hence be chosen to be smaller than the size of the filter elements. Hence the apertures need no longer be provided *via* an accurate photolithographic process. In addition a large resolving power of the barrier layer is no longer required.

The invention will now be described in greater detail with reference to the accompanying drawing, of which

Figure 1*a* is a diagrammatic sectional view of a part of a first embodiment of a colour imaging device,

Figure 1*b* is a plan view of the imaging device shown in Figure 1*a*,

Figures 2*a* to 2*d* show diagrammatically the various steps in the manufacture of the colour imaging device shown in Figure 1*a*,

Figure 3 is a diagrammatic sectional view of a part of a further embodiment of the colour imaging device shown in Figure 1*a*,

Figure 4 is a diagrammatic sectional view of a part of a second embodiment of a colour imaging device,

Figure 5*a* is a diagrammatic sectional view of a third embodiment of a colour imaging device, and

Figure 5*b* is a plan view of the imaging device shown in Figure 5*a*.

Figure 1*a* shows diagrammatically a part of a colour imaging device which is constructed as a so-called x-y sensor. The device 1 comprises a layer of semiconductor material 2, in which a large number of photodiodes 3 are formed arranged in rows and columns. A colour filter is provided on the system of photodiodes. The colour filter is formed by systems of filter elements 4 passing light of the colours red (R), green (G) and blue (B). The various systems of filter elements 4 form a so-called mosaic filter as is shown in Figure 1*b*, which is a plan view of Figure 1*a*. Each of the filter elements 4 is accurately in registration with an associated photodiode 3 in the semiconductor layer 2. The filter elements 4 are separated from each other by grooves 5 extending above the edges of the photodiodes 3. The semiconductor layer 2 comprises, for example, 500 × 300 photodiodes 3 having an area of approximately 300 μ$m^2$ on which the filter elements 4 are provided which are separated by grooves 5 having a width of approximately 1 to 5 μm.

Briefly, the operation of the imaging device is as follows. The scene to be picked up is displayed on the system of photodiodes 3 as a result of which charge is generated in the photodiodes 3. Each photodiode 3 is connected to a matrix of *x* and *y* conductors by means of a field effect transistor also formed in the semiconductor layer 2 but not shown in the Figure. The formed charge image is now read by driving the *x* and *y* conductors in the correct sequence.

The manufacture of the colour filter of the photosensitive elements 3 of the semiconductor layer 2 will be explained in detail with reference to Figures 2*a* to 2*d*. First a transparent layer 10 is provided on the semiconductor layer 2 in a thickness of approximately 0.5—3 μm (Figure 2*a*). The layer 10 is preferably also a photoresist. if the layer 10 itself is not a photoresist, a photoresist layer is provided on the transparent layer. The transparent layer is then exposed through a photomask which is provided with the pattern of grooves to be provided and which is accurately positioned with respect to the photosensitive elements 5 in the semiconductor layer 2. After developing the filter elements 4 shown in Figure 2*b* are obtained which are separated by grooves 5. By providing the grooves 5, the position of all filter elements 4 is fixed with respect to the photosensitive elements 3. An approximately 0.5—2 μm thick barrier layer 11, preferably a photoresist layer, is then provided (Fig. 2*c*). This layer 11 is then exposed through a mask which has a pattern of apertures. The layer 11 is then developed, the apertures 12 in the layer being obtained (see Figure 2*d*). The size of the apertures 12 is smaller than the size of the filter elements 4. As a result of this, great accuracy is not required for providing the apertures 12 in the barrier layer 11. Moreover, the resolving power of the barrier layer 11 need not be large. The apertures 12 are provided above all filter elements 4 which have to be dyed with, for example, a dye passing red light. The dye is provided *via* the apertures 12 and dyes the filter elements 4 by diffusion. Due to the grooves 5 red dye is prevented from entering filter elements 4 other than those for which it is destined. After dyeing the barrier layer 11 is removed. By repeating the provision of the barrier layer and the subsequent steps but with a dye passing green and blue light, respectively, for the various systems of filter elements 4, a mosaic colour filter is obtained as is shown in Figure 1*b*. The method described of manufacturing the colour filters will be described in greater detail with reference to the specific examples below.

Example I

A transparent photoresist layer is provided in a thickness of 1—2 μm on a semiconductor layer by means of spin-coating. The photoresist layer is of the polyvinyl cinnamate type, for example, the photoresist commercially available from Messrs. Kodak under the names KPR and KPL. The layer is dried at a temperature of 90°C for 10 minutes. The layer is then exposed through a photomask for 35 seconds by means of UV light having a wavelength of $300 < \lambda < 400$ nm. The non-exposed parts of the photoresist layer are removed by developing in toluene for 120 seconds, as a result of which filter elements are obtained which are separated by grooves. After drying the layer at 90°C for 10 minutes, an approximately 2 μm thick photoresist layer is provided as a barrier layer. The photoresist layer is a gelatin bichromate photoresist of, for example, the following composition in per cent by weight: 2% $(NH_4)_2Cr_2O_7$, 7.5% gelatin and 90.5% water. Instead of a gelatin bichromate photoresist, a fish glue bichromate photoresist may alternatively be used. The layer is dried at 50°C for 10 minutes. The layer is then exposed to UV light through a photo mask for 180 seconds. The non-exposed areas are removed by rinsing with water for 180 seconds. Herewith apertures are obtained in the barrier layer above the filter elements which are to be dyed first. Dyeing is carried out by means of a heat transfer dye which is dispersed in a binder layer of a polymer provided on a substrate. For example, for the blue dye the layer has the following composition in per cent by weight: 5% of a dye available from Messrs. BASF under the trade name Lurafix Blue F-RL, 4% cellulose acetate butryrate obtainable under the name Tenite II, EAB-381-20 from Messrs. Kodak, 36% ethyl alcohol, 36% ethyl glycol and 1% acetone. For the actual dyeing the semiconductor layer with filter elements, the barrier layer and the substrate with binder layer are heated to remove residues of solvents and water. The semiconductor layer with filter elements and barrier layer is then placed on the binder layer and heated to 210°C for 3 minutes. At this high temperature the dye may diffuse from the binder layer into the filter elements underlying the apertures in the barrier layer. After dyeing, the barrier layer is removed in a 50% sodium hydroxide solution at 80°C. After thoroughly rinsing and drying the process is repeated for dyeing the filter elements passing red and green light. In the binder layer the blue dye Lurafix Blue F-RL should be replaced by Lurafix Red RF for the red light-passing filter elements and a mixture of Lurafix Blue F-RL and Lurafix Yellow RL for the green light-passing filter elements, respectively.

Example II

A transparent photoresist layer is provided on a semiconductor layer again by means of spin-coating. The photoresist layer is a fish glue bichromate photoresist of, for example, the following composition in per cent by weight: 3.7% $(NH_4)_2Cr_2O_7$, 37.5% Norland Photogravers Glue obtainable from Messrs. Norland Products Inc., 6.3% acetone and 53.5% water. Instead of a fish glue bichromate photoresist, a gelatin bichromate photoresist may alternatively be used. The photoresist layer is dried at 50°C for 10 minutes. The layer is then exposed to UV light through a photo mask for 120 seconds. The layer is developed in running water for 2 minutes as a result of which photoelements are obtained which are separated by grooves. After drying the layer at 90°C for 10 minutes, an approximately 1 µm thick photoresist layer is provided as a barrier layer by means of spin coating. This photoresist layer is a positive photoresist of the naphtoquinone diazide type as is obtainable from Messrs. Shipley Company (USA) under the name Shipley AZ 1350. After exposure through a photo mask the layer is developed, for example, with Shipley AZ developer and then dried at 120°C for 10 minutes. The apertures in the barrier layer are then obtained. Dyeing the filter elements is carried out by means of aqueous solutions with wool dyes. A suitable solution for dyeing the red light-passing filter elements in per cent. by weight is composed of 1% Neopolar Brillant Rot B obtainable from Messrs. Ciba Geigy, 0.6% acetic acid, 0.8% sodium acetate, and 97.6% water; for dyeing the blue light-passing filter elements it is composed of 1% Sandolan-Wolkblau N-FRL obtainable from Messrs. Sandoz, 0.6% acetic acid, 0.8% sodium acetate and 97.6% water; and for the green light-passing filter elements it is composed of 0.3% Solophenyl Turkisch Blau BRL obtainable from Messrs. Ciba Geigy, 0.4% Erionyl grün 46 also from Messrs. Ciba Geigy, 0.3% Sandolan Echt Gelb PL 40 obtainable from Messrs. Sandoz, 0.6% acetic acid, 0.8% sodium acetate and 97.6% water. The dyes are supplied to the filter elements at 80°C for 5 minutes. After dyeing the positive photoresist is removed by rinsing with acetone.

A further embodiment will be described in greater detail with reference to Figure 3 in which the same reference numerals are used for the same components as in Figure 1*a*. At the area of the grooves 5, a 0.1—1 µm thick metal layer 15 of, for example, nickel is vapour-deposited on the layer of photo diodes 3. This is to prevent the disturbing effect of light which is incident on the photo diodes 3 through the narrow grooves 5. In the devices shown in Figures 1, 2 and 3 the colour filter is provided directly on the layer with photosensitive elements. This has for its advantage that by accurately providing the pattern of grooves the position of the filter elements is accurately fixed with respect to the photosensitive elements. The colour filter, however, may also be provided on a transparent substrate which, after alignment of the filter elements and the photosensitive elements, is connected to the semiconductor layer.

A method of manufacturing a second embodiment of a colour filter in accordance with the invention will be described in greater detail with reference to Figure 4. A transparent photoresist layer 20 having a thickness of approximately 0.5—3 µm is provided on the photo diodes 3 of the semiconductor layer 2 by means of spin coating. The layer 20 is a negative photoresist, i.e. a photoresist which becomes insoluble by exposure, and is further of the polymeric type. The transparent layer 20 is exposed, for example, to UV light through a photo mask which has the pattern of separation regions and which is accurately positioned with respect to the photo diodes 3. As a result of the exposure the exposed separation regions 22 obtain a structure different from the non-exposed regions of the filter elements 21. In fact, as a result of the exposure, cross-links are formed between the polymer chains of the layer 20 and the polymer becomes insoluble. Due to the formed cross-links the density of the polymer increases considerably so that the layer 20 at the area of the exposed separation regions 22 becomes substantially impervious to liquid. The dyeing of the systems of filter elements 21 is further carried out in the same manner as described with reference to Figures 2*c* and 2*d*, but the removal of the barrier layer may be succeeded by an exposure to UV light so as to make the material of the filter elements 21 insoluble.

It is also possible to use a transparent layer to be dyed in which separation regions are formed between the filter elements by chemically converting the layer at the area of the separation region into a structure which is substantially impervious to liquid.

In the above-described embodiments the imaging device is formed by an x-y sensor having photo diodes which comprises a mosaic filter. However, the invention may also be used in other types of sensors which, dependent on their structure, have to be provided with a mosaic filter or a stripe filter. For example, the invention may be used in a sensor having CCD's (Charge-Coupled Devices) which is constructed as a so-called frame-transfer sensor and which is to be provided with a stripe filter, or in a CID-sensor (Charge Injection Device) which may be provided with a mosaic filter.

A third embodiment of a colour imaging device in accordance with the invention will be described in greater detail with reference to Figure 5*a* which is a diagrammatic sectional view of a cathode-ray tube. The tube is formed by a glass envelope 31 having a window portion 32. On the inside of the window portion 32 a colour filter 39 is provided. The colour filter is a so-called stripe filter which is formed by stripe-shaped filter elements 39R, 39G and 39B passing respectively light of the colours red, green and blue. The filter elements are in turn separated by grooves which prevent the running of the dyes during dyeing and hence the occurrence of colour defects. Instead of grooves the filter elements may alternatively be separated from each other by separation regions having a structure which is substantially impervious to the dye. A very thin layer 40 of glass is provided over the stripe filter 39. Hereon three transparent interdigitated signal electrodes 43R, 43G and 43B are provided. The filter elements 39 are accurately in registration with the interdigitated signal elec-

trodes 43. Figure 5*b* shows the configuration of these three interdigitated electrodes 43R, 43G and 43B. A photoconductive layer 44 is provided over said signal electrodes 43. The tube furthermore comprises electrode means 35 having a cathode 36 for generating and focusing an electron beam directed on the layer 44. The tube is surrounded by a system of coils 37 for deflecting the electron beam over the photosensitive layer 44 according to a raster of substantially parallel lines. The scene to be picked up is projected on the photoconductive layer 44 through the colour filter 39. As a result of this a charge image is formed on the free surface of the layer 44 under the influence of the potentials applied to the signal electrodes 43. This charge image is reduced by the scanning electron beam, the video signal for each of the three colours being derived from the signal electrodes 43R, 43G and 43B *via* a resistor.

In the embodiment shown in Figure 5*a* the colour filter is provided directly on the window portion of the cathode-ray tube. However, it is alternatively possible to provide the colour filter on a glass plate and to secure said glass plate to the cathode-ray tube.

The invention has been explained with reference to embodiments in which the colour filter is constructed from a stripe filter or a mosaic filter having filter elements passing light of the colours red, green and blue. However, the invention is not restricted to colour filters having filter elements passing primary colours of light. The colour filters may alternatively be constructed with filter elements passing light of the complementary colours cyan, magenta and yellow or with combinations of filter elements passing light of primary and complementary colours. For example, colour filters may be provided with filter elements passing light of the colours red, green and cyan, with filter elements passing light of the colours white, green, yellow and cyan, or with filter elements passing light of the colours white, yellow and cyan.

**Claims**

1. A colour imaging device comprising an imaging device having a colour filter comprising a dyed single layer provided on a substrate of the imaging device and having at least two systems of filter elements, each system of filter elements passing a different colour of light, characterized in that the layer of filter elements has separation regions which completely separate the filter elements from neighbouring filter elements.

2. A colour imaging device as claimed in Claim 1, characterized in that the separation regions are grooves provided in the layer.

3. A colour imaging device as claimed in Claim 1, characterized in that the separation regions comprise a material which is substantially impervious to liquid.

4. A colour imaging device as claimed in Claim 1, 2 or 3, characterized in that the separation regions comprise a light-impervious material.

5. A colour imaging device as claimed in Claim 1, 2, 3 or 4, characterized in that the imaging device comprises a semiconductor layer which has a system of photo-sensitive elements.

6. A colour imaging device as claimed in Claim 5, characterized in that the colour filter is provided directly on the semiconductor layer.

7. A colour imaging device as claimed in Claim 5, characterized in that the colour filter is provided on a transparent substrate, which substrate is provided on the semiconductor layer.

8. A colour imaging device as claimed in Claim 1, 2, 3 or 4, characterized in that the imaging device comprises a cathode-ray tube having a window portion which on the inside has a photo-sensitive layer, the colour filter being present between the photo-sensitive layer and the window portion.

9. A colour imaging device as claimed in Claim 8, characterized in that the colour filter is provided directly on the window portion of the cathode-ray tube.

10. A colour imaging device as claimed in Claim 8, characterized in that the colour filter is provided on a transparent substrate, which substrate is provided on the window portion of the cathode-ray tube.

11. A method of manufacturing a colour imaging device as claimed in any of the preceding Claims comprising the steps of

a) providing an imaging device substrate;

b) providing on the substrate a transparent layer which can be coloured by dyes;

c) providing, by means of a photolithographic process, a pattern of separation regions in the transparent layer to form filter elements in the layer which are completely separated from neighbouring filter elements;

d) providing a barrier layer over the transparent layer;

e) providing, by means of a photolithographic process, a pattern of apertures in the barrier layer, which pattern of apertures corresponds to a first system of filter elements;

f) providing, *via* the apertures in the barrier layer, a dye in the filter elements of the first system, and

g) removing the barrier layer.

12. A method as claimed in Claim 11, characterized in that the steps d) to g) are repeated to form at least a further system of filter elements passing light of a different colour than the first system of filter elements.

**Revendications**

1. Dispositif de prise de vues en couleurs comportant un dispositif de prise de vues présentant un filtre de couleur, muni d'une seule couche colorée appliquée sur un substrat du dispositif de prise de vues et présentant au moins deux systèmes d'éléments de filtrage, chaque système d'éléments de filtrage (transmettant une lumière de couleur différente) caractérisé en ce que la couche des éléments de filtrage présente des régions de séparation, qui séparent complètement les éléments de filtrage des éléments de filtrage voisins.

2. Dispositif de prise de rues en couleurs selon la revendication 1, caractérisé en ce que les régions de séparation sont des rainures ménagées dans la couche.

3. Dispositif de prise de vues en couleurs selon la revendication 1, caractérisé en ce que les régions de séparation comportent un matériau, qui est pratiquement imperméable au liquide.

4. Dispositif de prise de vues en couleurs selon la revendication 1, 2 ou 3, caractérisé en ce que les régions de séparation comportent un matériau opaque à la lumière.

5. Dispositif de prise de vues en couleurs selon la revendication 1, 2, 3 ou 4, caractérisé en ce que le dispositif de prise de vues comporte une couche semiconductrice, qui présente un système d'éléments photosensibles.

6. Dispositif de prise de vues en couleurs selon la revendication 5, caractérisé en ce que le filtre de couleur est disposé de façon directe sur la couche semiconductrice.

7. Dispositif de prise de vues de couleurs selon la revendication 5, caractérisé en ce que le filtre de couleur est disposé sur un substrat transparent, qui est appliqué sur la couche semiconductrice.

8. Dispositif de prise de vues en couleurs selon la revendication 1, 2, 3 ou 4, caractérisé en ce que le dispositif de prise de vues comporte un tube à rayons cathodiques présentant une partie de fenêtre sur la face intérieure de laquelle est présente une couche photosensible, le filtre de couleur étant présent entre la couche photosensible et la partie de fenêtre.

9. Dispositif de prise de vues selon la revendication 8, caractérisé en ce que le filtre de couleur est disposé de façon directe sur la partie de fenêtre du tube à rayons cathodiques.

10. Dispositif de prise de vues en couleurs selon la revendication 8, caractérisé en ce que le filtre de couleur est disposé sur un substrat transparent, qui est appliqué sur la partie de fenêtre du tube à rayons cathodiques.

11. Procédé pour la réalisation d'un dispositif de prise de vues en couleurs selon l'une des revendications précédentes comprenant les étapes de

a) la réalisation d'un substrat pour le dispositif de prise de vues:

b) l'application d'une couche transparente sur le substrat, couche transparente qui peut être colorée à l'aide de colorants;

c) la réalisation, à l'aide d'un processus photolithographique, d'une configuration de régions de séparation dans la couche transparente afin de former dans la couche des éléments de filtrage qui sont complètement séparés des éléments de filtrage voisins;

d) l'application d'une couche de barrière sur la couche transparente,

e) la réalisation, à l'aide d'un processus photolithographique, d'une configuration d'ouvertures dans la couche de barrière, ces configurations correspondant à un premier système d'élements de filtrage;

f) l'application, par l'intermédiaire des ouvertures de la couche de barrière, d'un colorant dans les éléments de filtrage du premier système et

g) l'enlèvement de la couche de barrière.

12. Dispositif selon la revendication 11, caractérisé en ce que les étapes d) à g) sont repétées afin de former au moins un autre système d'éléments de filtrage transmettant de la lumière d'une autre couleur qu'un premier système d'éléments de filtrage.

**Patentansprüche**

1. Farbbildaufnahmeanordnung mit einer Bildaufnahmeanordnung mit einem Farbfilter mit einer einzigen gefärbten Schicht, die auf einem Substrat der Bildaufnahmeanordnung vorgesehen ist und mit wenigstens zwei Systemen von Filterelementen, wobei jedes System von Filterelementen einen anderen Farbton durchlässt, dadurch gekennzeichnet, dass die Schicht von Filterelementen Trenngebiete aufweist, die die Filterelemente von benachbarten Filterelementen völlig trennt.

2. Farbbildaufnahmeanordnung nach Anspruch 1, dadurch gekennzeichnet, dass die Trenngebiete in der Schicht vorgesehene Rillen sind.

3. Farbbildaufnahmeanordnung nach Anspruch 1, dadurch gekennzeichnet, dass die Trenngebiete ein Material enthalten das für Flüssigkeit nahezu undurchdringlich ist.

4. Farbbildaufnahmeanordnung nach Anspruch 1, 2 oder 3, dadurch gekennzeichnet, dass die Trenngebiete ein lichtundurchlässiges Material enthalten.

5. Farbbildaufnahmeanordnung nach Anspruch 1, 2, 3 oder 4, dadurch gekennzeichnet, dass die Bildaufnahmeanordnung eine Halbleiterschicht aufweist, die ein System von lichtempfindlichen Elementen aufweist.

6. Farbbildaufnahmeanordnung nach Anspruch 5, dadurch gekennzeichnet, dass das Farbfilter unmittelbar auf der Halbleiterschicht angeordnet ist.

7. Farbbildaufnahmeanordnung nach Anspruch 5, dadurch gekennzeichnet, dass das Farbfilter auf einem transparenten Substrat angeordnet ist, wobei dieses Substrat auf der Halbleiterschicht vorgesehen ist.

8. Farbbildaufnahmeanordnung nach Anspruch 1, 2, 3 oder 4, dadurch gekennzeichnet, dass die Bildaufnahmeanordnung eine Elektronenstrahlröhre aufweist, die einen Fensterteil aufweist, der auf der Innenseite mit einer lichtempfindlichen Schicht versehen ist, wobei das Farbfilter zwischen der lichtempfindlichen Schicht und dem Fensterteil vorgesehen ist.

9. Farbbildaufnahmeanordnung nach Anspruch 8, dadurch gekennzeichnet, dass das Farbfilter unmittelbar auf dem Fensterteil der Elektronenstrahlröhre vorgesehen ist.

10. Farbbildaufnahmeanordnung nach Anspruch 8, dadurch gekennzeichnet, dass das Farbffilter auf einem transparenten Substrat vorgesehen ist, wobei dieses Substrat auf dem Fensterteil der Elektronenstrahlröhre angeordnet ist.

11. Verfahren zum Herstellen einer Farbbildaufnahmeanordnung nach einem der vorstehenden Ansprüche mit den folgenden Schritten:

a) das Anbringen eines Bildaufnahmeanordnungssubstrat;

b) das Anbringen einer transparenten Schicht auf dem Substrat, wobei diese Schicht durch Farbstoffe eingefärbt werden kann;

c) das mit Hilfe eines photolithographischen Verfahrens Anbringen eines Musters von Trenngebieten in der transparenten Schicht zum Bilden von Filterelementen in der Schicht, die gegenüber benachbarten Filterelementen völlig getrennt sind;

d) das Anbringen einer Sperrschicht über der transparenten Schicht;

e) das mittels eines photolithographischen Verfahrens Anbringen eines Musters von Öffnungen in der Sperrschicht, wobei dieses Muster von Öffnungen einem ersten System von Filterelementen entspricht;

f) das durch die Öffnungen in der Sperrschicht hindurch Anbringen eines Farbstoffes in den Filterelementen des ersten Systems und

g) das Entfernen der Sperrschicht.

12. Verfahren nach Anspruch 11, dadurch gekennzeichnet, dass die Stufen d) bis g) zum Bilden jedes nachfolgenden Systems von für Licht mit einem anderen Farbton durchlässigen Filterelementen wiederholt werden.

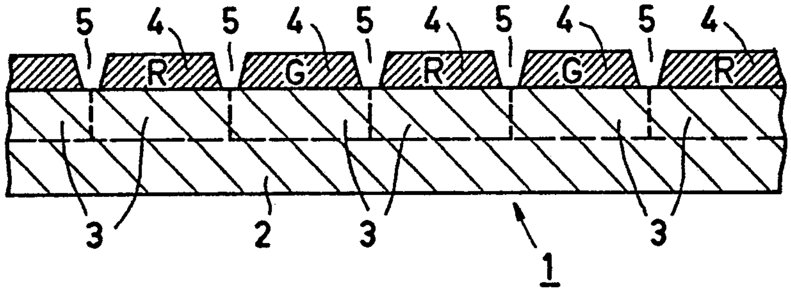
5
4
5
4
5
4
5
4
5
4
R
G
R
G
R
3
2
3
3
1

FIG.1a

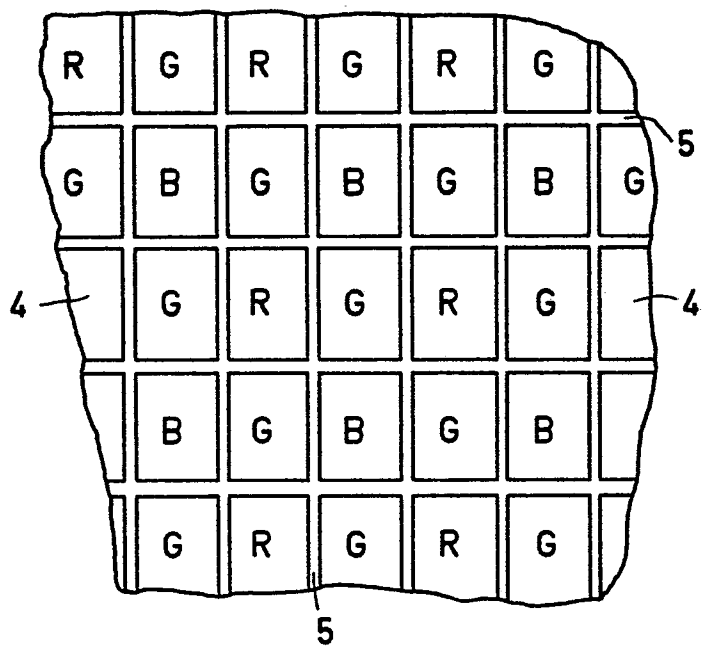
R G R G R G
G B G B G B G
G R G R G
B G B G B
G R G R G
5
4
4
5

FIG.1b

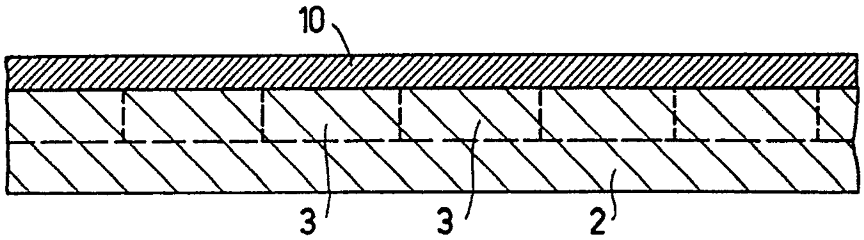


FIG.2a

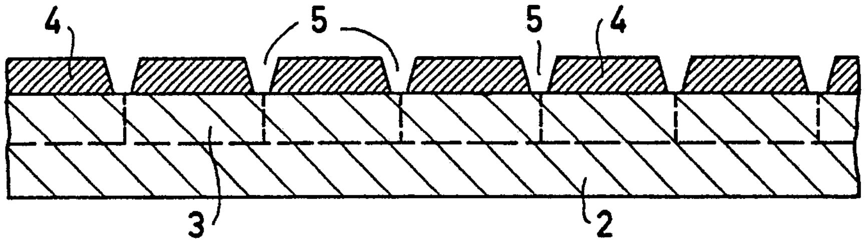


FIG.2b

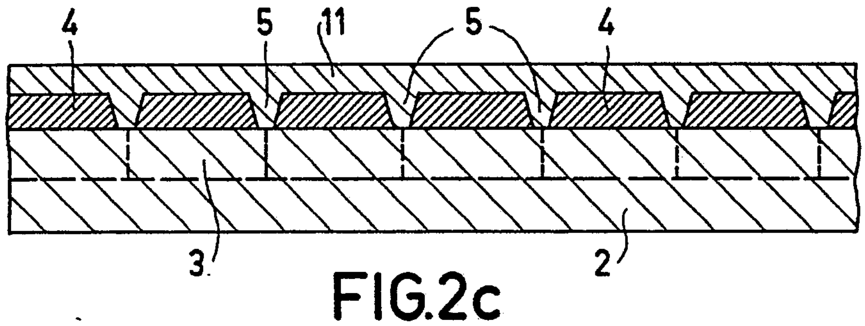


FIG.2c

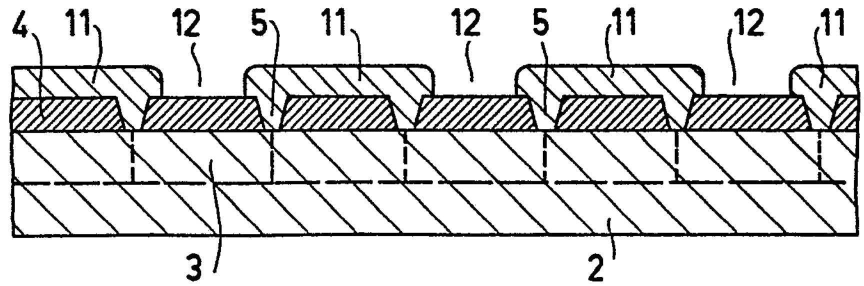


FIG.2d

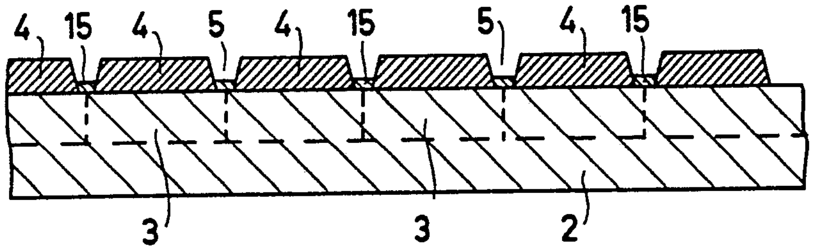


FIG.3

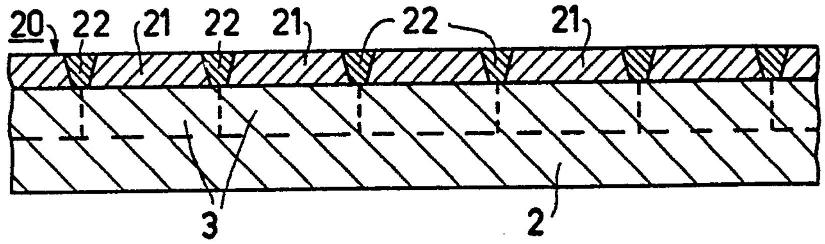


FIG.4

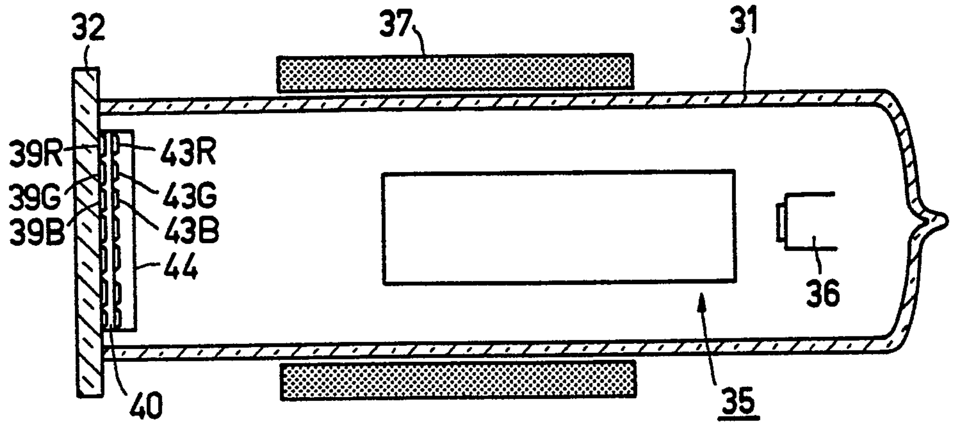


FIG.5a

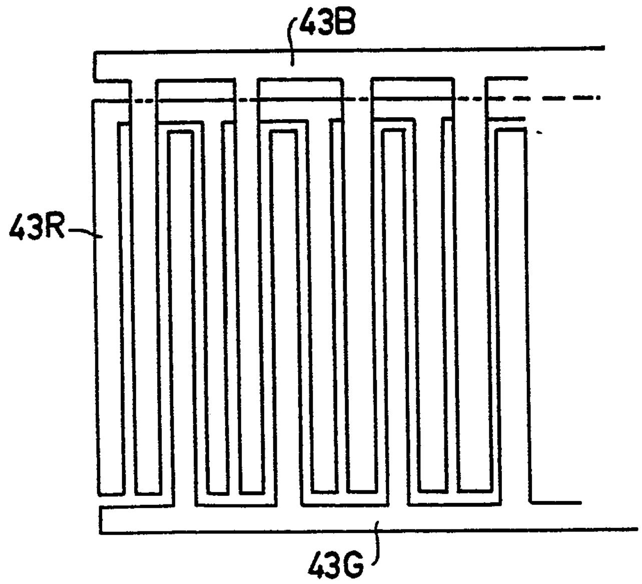


FIG.5b